# EUROPEAN PATENT APPLICATION

(11) **EP 3 674 451 A1**
(43) Date of publication of application: **01.07.2020**
(21) Application number: 18849948.7
(22) Date of filing: 27.06.2018
(51) Int. Cl.: C30B 29/38, B23K 26/53, B28D 5/04, C30B 33/02, H01L 21/304

(54) **METHOD FOR MANUFACTURING SUBSTRATE**

(30) Priority: 01.09.2017 JP 2017168569
(71) Applicant: National University Corporation Nagoya University, Nagoya-shi, Aichi 464-8601 (JP); Hamamatsu Photonics K.K., Hamamatsu-shi, Shizuoka 435-8558 (JP)
(72) Inventor: TANAKA Atsushi, Nagoya-shi Aichi 464-8601 (JP); KAWAGUCHI Daisuke, Hamamatsu-shi Shizuoka 435-8558 (JP)
(74) Representative: Kramer Barske Schmidtchen Patentanwälte PartG mbB
(86) International application number: PCT/JP2018/024353
(87) International publication number: WO 2019/044142

(57) **Abstract**

A technique related to a substrate manufacturing method is provided. The substrate manufacturing method comprises irradiating laser into an ingot of gallium nitride (GaN) along a direction substantially vertical to a surface of the ingot and forming a reformed layer in which gallium has precipitated and that is substantially parallel to the ingot surface. The substrate manufacturing method comprises separating the ingot into a plurality with a position where the reformed layer has been formed as a boundary by dissolving the reformed layer.

## Description

### TECHNICAL FIELD

This application claims priority to Japanese Patent Application No. 2017-168569 filed on September 1, 2017, the contents of which are hereby incorporated by reference into the present application. The description herein discloses an art related to a substrate manufacturing method.

### BACKGROUND ART

JP 2017-57103 A describes a method of producing gallium nitride substrates from a gallium nitride ingot. Specifically, an interface in which gallium and nitrogen are precipitated is formed by irradiating laser beam onto the gallium nitride ingot. A first retaining member is adhered to a first surface of the ingot and a second retaining member is adhered to a second surface of the ingot. The gallium nitride substrates are formed by separating the ingot at the interface by heating the ingot to a temperature at which gallium melts and moving the first and second retaining members to directions separating away from each other.

### SUMMARY OF INVENTION

### TECHNICAL PROBLEM

In the technique of Patent Document 1, the first and second surfaces of the ingot are moved in the directions separating away from each other. In doing so, there is a risk that the gallium nitride substrates break due to external force being applied to the gallium nitride substrates upon separation.

### SOLUTION TO PROBLEM

The present description discloses a method of manufacturing a substrate. The method comprises irradiating laser into an ingot of gallium nitride (GaN) along a direction substantially vertical to a surface of the ingot and forming a reformed layer in which gallium has precipitated and that is substantially parallel to the ingot surface. The method comprises separating the ingot into a plurality with a position where the reformed layer has been formed as a boundary by dissolving the reformed layer.

In the substrate manufacturing method in the description herein, the reformed layer is formed inside the gallium nitride ingot, and the ingot can be separated into a plurality by dissolving the reformed layer. As compared to a case of moving first and second surfaces of an ingot in directions separating away from each other, force applied to the ingot can be suppressed. A situation in which separated substrates break can be avoided.

The separating of the ingot may include dissolving the reformed layer by a chemical solution.

The separating of the ingot may be performed by immersing the ingot in a tank filled with the chemical solution.

The irradiating of the laser may include forming N layers (N being a natural number of 2 or more) of the reformed layers at different depths from the ingot surface. The separating of the ingot may include separating the ingot into N+1 pieces by dissolving each of the N layers of the reformed layers.

The separating of the ingot may include using the chemical solution in a heated state.

The chemical solution may be aqua regia.

The separating of the ingot may include dissolving the reformed layer by heating the reformed layer to a temperature that is higher than a melting point of gallium.

The separating of the ingot may include separating the ingot into a plurality by applying force to a front surface of the ingot in a first direction parallel to the front surface and applying force to a rear surface of the ingot in a second direction opposite the first direction and parallel to the rear surface.

### BRIEF DESCRIPTION OF DRAWINGS

FIG. 1 is a flow chart explaining a substrate manufacturing method of a first embodiment.
FIG. 2 is a diagram showing an example of an ingot in which reformed layers are formed.
FIG. 3 is a schematic diagram of a laser irradiation device.
FIG. 4 is a schematic diagram of a chemical solution tank.
FIG. 5 is a flow chart explaining a substrate manufacturing method of a second embodiment.

### DESCRIPTION OF THE EMBODIMENTS

### First Embodiment

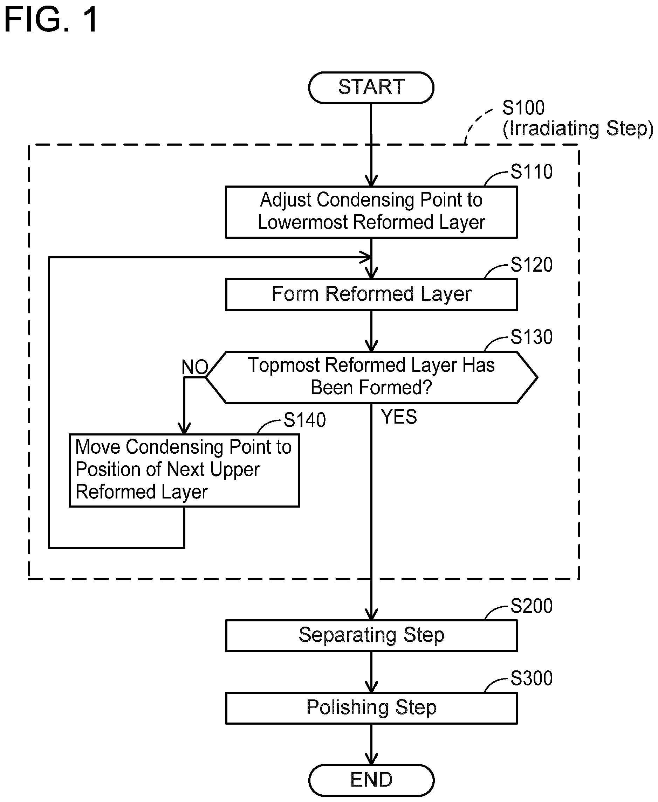

A substrate manufacturing method of a first embodiment will be described with reference to a flow of FIG. 1. The substrate manufacturing method is provided with an irradiating step of step S100, a separating step of step S200, and a polishing step of step S300.

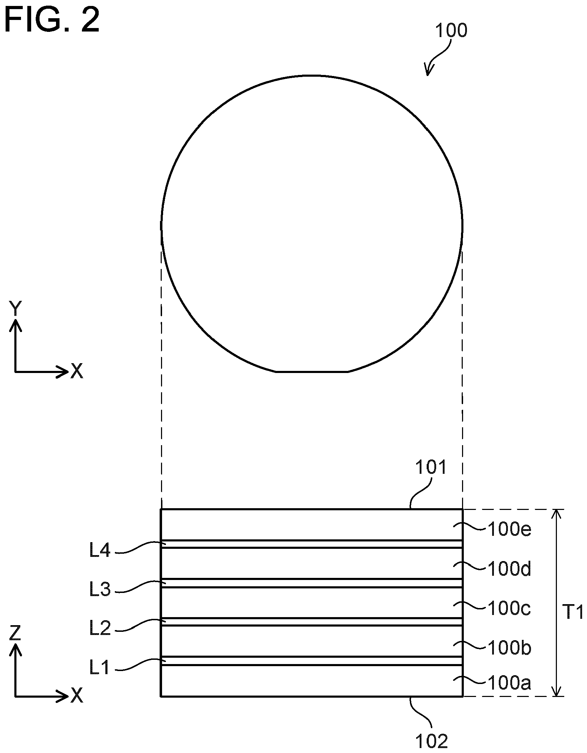

The irradiating step of step S100 will be described. The irradiating step is a step of forming N (N being a natural number of 2 or more) reformed layers within an ingot. FIG. 2 shows an example of an ingot 100 in which reformed layers are formed by the irradiating step. FIG. 2 shows a top view and a side view of the ingot 100. In this embodiment, an example in which the ingot 100 has a diameter of 100mm and a thickness T1 of 0.5mm will be described. Further, a case in which a number of the reformed layers is four will be described. The ingot 100 is constituted of a gallium nitride (GaN) monocrystal. The GaN monocrystal is transparent. The ingot 100 includes four reformed layers L1 to L4 at different depths from its surface 101 of the ingot 100. The reformed layers are layers in which gallium has precipitated. The reformed layers are black. The ingot 100 is divided into five substrate layers 100a to 100e by the four reformed layers L1 to L4. A thickness of each of the reformed layers L1 to L4 is 10 micrometers, for example. A thickness of each of the substrate layers 100a to 100e is 100 micrometers or less, for example.

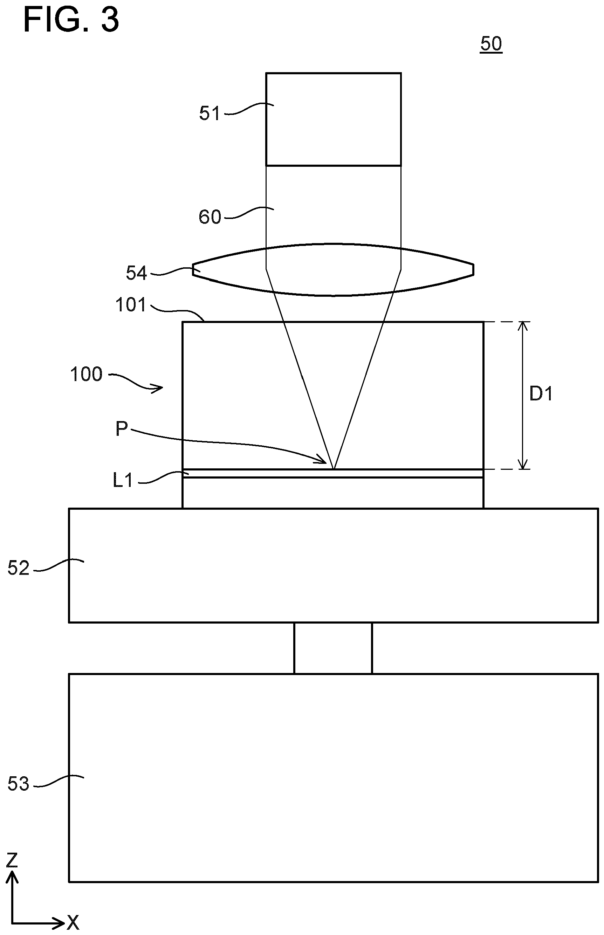

FIG. 3 shows a schematic view of a laser irradiation device 50 used in the irradiating step. The laser irradiation device 50 is provided with a laser generating unit 51, a stage 52, a stage driving unit 53, and a condensing lens 54. The laser generating unit 51 is a unit configured to output laser 60. The laser 60 is configured to be irradiated into the ingot 100 along a direction substantially vertical to the surface 101 of the ingot 100. The stage 52 is a unit for mounting the ingot 100 thereon. The stage driving unit 53 is a unit configured to move the stage 52 in X and Y directions (directions within a plane that is vertical to the laser 60). The condensing lens 54 is an object lens for condensing the laser 60 so that it focuses at a condensing point P within the ingot 100. Further, the condensing lens 54 is provided with a mechanism that is not shown for adjusting a position of the condensing point P in a Z direction (a direction parallel to the laser 60).

The irradiating step of step S100 includes steps S110 to S140. In step S110, the condensing lens 54 is adjusted so that the condensing point P is positioned at a depth where the lowermost reformed layer L1 is to be formed. As shown in FIG. 3, the lowermost reformed layer L1 is a reformed layer formed at a depth D1 from the surface 101.

In step S120, the lowermost reformed layer L1 is formed. This will be described in detail. The laser 60 is outputted from the laser generating unit 51. The laser 60 has the condensing point P at the depth D1 from the surface 101. Since a surrounding of the condensing point P is locally heated, nitrogen in GaN thereof gasifies and evaporates, by which gallium precipitates. The reformed layer L1 is formed by this layer in which gallium has precipitated. Further, the laser 60 is scanned relative to the ingot 100 by moving the stage 52 in the X and Y directions while maintaining the condensing point P at the depth D1. By doing so, the reformed layer L1 having a planar shape can be formed. Flat surfaces forming the reformed layer L1 are parallel to the ingot surface 101.

In step S130, a determination is made on whether or not the reformed layer L4 being the topmost reformed layer has been formed. In case of making a negative determination (S130: NO), the process proceeds to S140 and the condensing lens 54 is adjusted to move the condensing point P to a depth for forming the next upper reformed layer. Then, the process returns to S120, and the reformed layer is formed. Due to this, the reformed layers LI to L4 are formed one layer at a time from a lower side. That is, the reformed layer L1 located at the deepest position from the surface 101 to the reformed layer L4 located at the shallowest position therefrom are formed one after another. Due to this, formation of a subsequent reformed layer is suppressed from being hindered by a presence of a previously-formed reformed layer.

Then, when the topmost reformed layer L4 has been formed, an affirmative determination (S130: YES) is made in step S130 and the irradiating step of step S100 is completed.

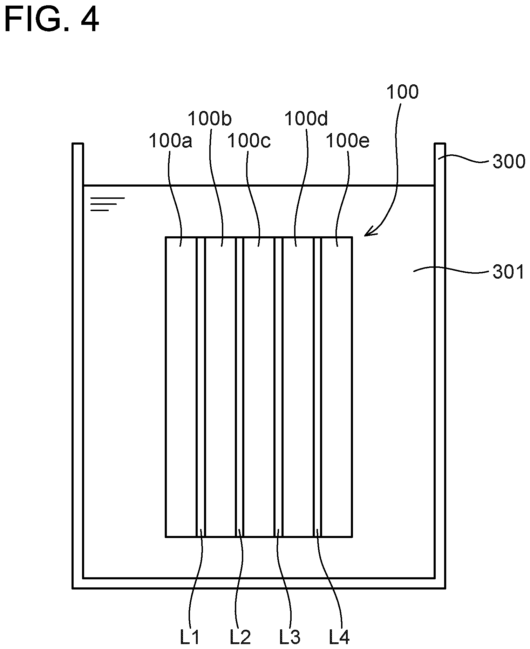

The separating step of step S200 will be described. The separating step is a step of separating the substrate layers 100a to 100e of the ingot from each other with positions where the reformed layers L1 to L4 were formed as boundaries therebetween by dissolving the respective reformed layers L1 to L4. FIG. 4 shows a schematic view of a chemical solution tank 300 used in the separating step. The chemical solution tank 300 is filled with a chemical solution 301 for dissolving gallium. An example of the chemical solution 301 may be strong acid or an alkali metal hydroxide solution (e.g.: sodium hydroxide). In the present embodiment, a case will be described in which aqua regia is used as the chemical solution 301. The aqua regia is a chemical solution that mixed concentrated hydrochloric acid and concentrated nitric acid solution at a volume ratio of 3:1.

The ingot 100 in which the reformed layers L1 to L4 are formed is immersed in the chemical solution tank 300. By doing so, each of the four reformed layers L1 to L4 is dissolved, and the ingot 100 can be separated into five substrate layers 100a to 100e.

Advantageous effects will be described. In the separating step of the present embodiment, force to separate the substrate layers 100a to 100e (e.g.: force for moving a front surface 101 and a rear surface 102 in directions separating away from each other) does not need to be applied to the ingot 100. As such, a situation in which the substrate layers 100a to 100e break upon separation can be suppressed. Further, by dissolving the four reformed layers L1 to L4 in the chemical solution tank 300, the five substrate layers 100a to 100e can be separated simultaneously. Efficiency of the separating step can be enhanced as compared to a case of separating the substrate layers one by one.

The reformed layers L1 to L4 may be dissolved in a state of having heated the chemical solution 301 in the chemical solution tank 300. For example, a state of being heated to about 80°C may be maintained. As a first advantageous effect, a dissolving speed of the reformed layers can be increased by promoting the chemical reaction. Further, as a second advantageous effect, the chemical solution tank 300 can be functioned as a hot bath tank. Since gallium has a low melting point of 29.76°C, the reformed layers L1 to L4 can be melted by heating the reformed layers L1 to L4 to a temperature higher than the melting point of gallium. According to the above, processing time of the separating step can be shortened.

Further, the chemical solution 301 in the chemical solution tank 300 may be stirred or may be bubbled by using inert gas such as N₂ while dissolving the reformed layers. By doing so, the dissolving speed of the reformed layers can be increased by constantly supplying a fresh chemical solution to vicinities of the reformed layers.

When the separating step of step S200 is completed, the polishing step of step S300 is carried out. The polishing step is a step of polishing front and rear surfaces of each of the substrate layers 100a to 100e separated in the separating step. By doing so, damaged layers can be removed and flattening can be performed. The polishing step may be carried out for example by using a CMP (Chemical Mechanical Polishing method). In an ordinary method of slicing the ingot using a wire saw, thick damaged layers of about 100 micrometers are formed on both surfaces of each substrate, thus a polishing amount is very large. On the other hand, in the method of slicing the ingot using the laser as in the present embodiment, a thickness of damaged layers formed on both surfaces of each substrate can be suppressed to 10 micrometers or less, so a polishing amount can be suppressed. Due to this, as compared to the case of using the wire saw, polishing time can significantly be shortened, and a number of substrates produced from one ingot can be increased. As a result, the GaN substrates can be produced at low cost.

### Second Embodiment

A second embodiment differs from the first embodiment in regard to contents of the separating step of step S200. Since contents of steps S100 and S300 are same as the first embodiment, the descriptions thereof will be omitted.

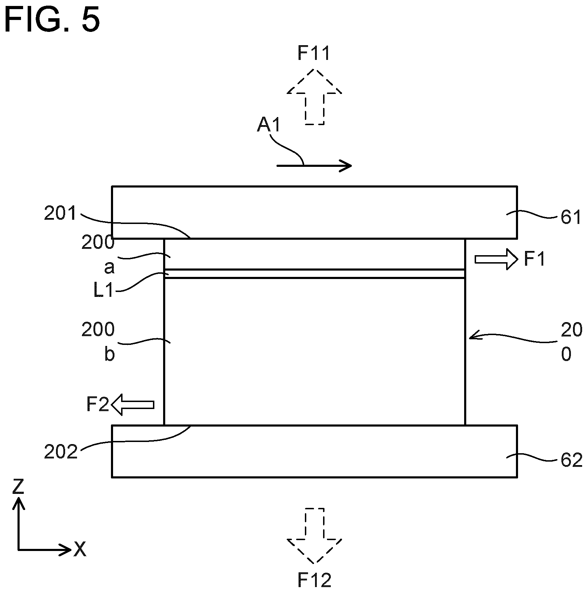

FIG. 5 shows an ingot 200 being a processing target of the separating step of the second embodiment. The ingot 200 is divided into substrate layers 200a and 200b by one reformed layer L1. A thickness of the substrate layer 200a is 100 micrometers or less, for example. A thickness of the substrate layer 200b may be thicker than the substrate layer 200a.

Specific contents of the separating step will be described. A front surface 201 of the ingot 200 is retained by a chuck 61 and a rear surface 202 thereof is retained by a chuck 62. Retention by the chucks may be carried out by vacuum suction or by fixation using adhesive. Then, a state in which the reformed layer L1 is heated to a temperature higher than a melting point of gallium is maintained. Heating of the reformed layer L1 may be carried out by heating the chucks 61 and 62. Due to this, the reformed layer L1 can be melted.

Then, the chuck 61 is moved in a horizontal direction A1 in a state of having fixed the chuck 62 and heating the reformed layer L1. Force F1 in a X direction parallel to the front surface can be applied to the front surface 201 of the ingot 200. Further, force F2 in a direction parallel to the rear surface and opposite to the X direction can be applied to the rear surface 202 of the ingot 200. By doing so, the ingot 200 can be separated by shearing force.

Advantageous effects will be described. As shown in FIG. 5, when force F11 and force F12 for moving the front surface 201 and the rear surface 202 in directions separating away from each other are to be applied, bending force is applied along a thickness direction of the substrate layer 200a. Since the thickness of the substrate layer 200a is 100 micrometers or less, there may be a case in which the substrate layer 200a thereby breaks. On the other hand, in the case of applying the shearing force on the front surface 201 and the rear surface 202 as in the second embodiment, bending force is applied along a diameter direction of the substrate layer 200a. A diameter of the substrate layer 200a is 100mm and is sufficiently large relative to its thickness, thus a situation in which the substrate layer 200a breaks can be suppressed.

### <Modification>

An embodiment of the present invention has been described in detail with reference to the drawings, however, this is a mere exemplary indication and thus does not limit the scope of the claims. The art described in the claims includes modifications and variations of the specific examples presented above.

The art disclosed herein is not limited to gallium nitride (GaN), and may be applied to various types of compound semiconductor substrate production. For example, it may be applied to formation of other nitride semiconductor substrates, such as aluminum nitride (A1N) and indium nitride (InN).

Numerical values described in the description herein are mere exemplary indications. For example, there were four reformed layers and five substrate layers in the first embodiment. Further, the ingot 100 had the diameter of 100mm and the thickness T1 of 0.5mm. However, these numerical values are mere exemplary indications, and no limitation is made to these values. Further, the same applies to the thicknesses of the reformed layers and the substrate layers.

Technical features described in the description and the drawings may technically be useful alone or in various combinations, and are not limited to the combinations as originally claimed. Further, the art described in the description and the drawings may concurrently achieve a plurality of aims, and technical significance thereof resides in achieving any one of such aims.

## Claims

1. A method of manufacturing a substrate, the method comprising:
irradiating laser into an ingot of gallium nitride (GaN) along a direction substantially vertical to a surface of the ingot and forming a reformed layer in which gallium has precipitated and that is substantially parallel to the ingot surface; and
separating the ingot into a plurality with a position where the reformed layer has been formed as a boundary by dissolving the reformed layer.

2. The method of manufacturing a substrate according to claim 1, wherein the separating of the ingot includes dissolving the reformed layer by a chemical solution.

3. The method of manufacturing a substrate according to claim 2, wherein the separating of the ingot is performed by immersing the ingot in a tank filled with the chemical solution.

4. The method of manufacturing a substrate according to claim 3, wherein
the irradiating of the laser includes forming N layers (N being a natural number of 2 or more) of the reformed layers at different depths from the ingot surface, and
the separating of the ingot includes separating the ingot into N+1 pieces by dissolving each of the N layers of the reformed layers.

5. The method of manufacturing a substrate according to any one of claims 2 to 4, wherein the separating of the ingot includes using the chemical solution in a heated state.

6. The method of manufacturing a substrate according to any one of claims 2 to 5, wherein the chemical solution is aqua regia.

7. The method of manufacturing a substrate according to claim 1, wherein the separating of the ingot includes dissolving the reformed layer by heating the reformed layer to a temperature that is higher than a melting point of gallium.

8. The method of manufacturing a substrate according to claim 7, wherein the separating of the ingot includes separating the ingot into a plurality by applying force to a front surface of the ingot in a first direction parallel to the front surface and applying force to a rear surface of the ingot in a second direction opposite the first direction and parallel to the rear surface.
